# EUROPÄISCHE PATENTSCHRIFT

(11) **EP 0 395 013 B1**
(45) Veröffentlichungstag und Bekanntmachung des Hinweises auf die Patenterteilung: **11.08.1993**
(21) Anmeldenummer: 90107863.4
(22) Anmeldetag: 25.04.1990
(51) Int. Cl.: H01F 15/10

(54) **Anwickel- und Lötanschluss für ein oberflächenmontierbares induktives elektrisches Bauelement**
Wound- and welded terminal for a surface mountable inductive electric component
Borne enroulée et sondée pour composant inductif électrique à montage en surface

(30) Priorität: 27.04.1989 DE 3913977
(43) Veröffentlichungstag der Anmeldung: 31.10.1990
(73) Patentinhaber: SIEMENS AKTIENGESELLSCHAFT, 80333 München (DE)
(72) Erfinder: Roland, Ehrgott, D-8000 München 83 (DE)

(56) Entgegenhaltungen:
- PATENT ABSTRACTS OF JAPAN vol. 11, no. 182 (E-515)(2629) 11 Juni 1987, & JP-A-62 15810 (MASAKAZU) 24 Januar 1987,
- PATENT ABSTRACTS OF JAPAN vol. 10, no. 313 (E-448)(2369) 24 Oktober 1986, & JP-A-61 125003 (HIROSHI) 12 Juni 1986,

## Beschreibung

Die Erfindung betrifft einen Anwickel- und Lötanschluß für ein oberflächenmontierbares induktives elektrisches Bauelement, insbesondere für den Spulenkörper einer elektrischen Spule, der in einem Trägerteil des Bauelementes gehalten ist und ein stift-, streifen- oder lötösenförmiges erstes Element zur Kontaktierung des Bauelements auf einer Leiterplatte aufweist.

Bereits bekannte oberflächenmontierbare elektrische Spulen, d.h. sogenannte SMD Spulen tragen flache bzw. streifenförmige Anschlußbeinchen zum Anwickeln der Wicklungsenden, die üblicherweise durch Tauchlöten mit den Leiterbahnen elektrischer Leiterplatten verbunden werden. Bedingt durch die jeweilige Gestaltung des Bauelements und seiner Anschlüsse ist beim Anwickeln und Tauchlöten der Wicklungsenden nicht ausgeschlossen, daß eine thermische oder mechanische Schädigung in dem Anschlußbereich und ggf. auch in dem Bereich des Bauelements auftritt, die zum Kontaktieren des Bauelements auf der Leiterplatte benötigt werden.

Aus Patent Abstracts of Japan, Volume 11, Nr. 182 (E-515) (2629) vom 11. Juni 1987 ist es zur Sicherstellung der Verbindung eines ummantelten elektrischen Drahtes kleinen Durchmessers mit einem Anschluß ohne Gefahr eines Drahtbruchs bekannt, auf der Oberfläche des Anschlusses einen Metallfilm auszubilden, dessen Schmelzpunkt kleiner als die isolierende Ummantelung des elektrischen Drahtes ist, und durch einen Schmelzstrom die Verbindung des ummantelten elektrischen Drahtes mit dem Anschluß herzustellen.

Aus Patent Abstracts of Japan, Volume 10, Nr. 313 (I-448) (2369) vom 24. Oktober 1986 ist es bei einem Chip-förmigen Spulenelement bekannt, zur Realisierung eines dreidimensional großen Verbindungsbereiches zwischen an einen Kern angepaßten und mit diesem zu verbindenden Anschlußplatten an diesen Anschlußplatten Ansätze vorzusehen, welche an in der Endfläche der Kerne ausgebildete Hohlräume angepaßt und in diese einschiebbar sind.

Der vorliegenden Erfindung liegt die Aufgabe zugrunde, einen Anwickel- und Lötanschluß der eingangs genannten Art zu schaffen, der ein problemloses automatisches Anwickeln und Tauchlöten der Wicklungsenden und das Kontaktieren des Bauelements auf einer Leiterplatte ermöglicht; d.h. die Anschlüsse sollen so gestaltet sein, daß die bereits erwähnte thermische oder mechanische Schädigung im Anschlußbereich vermieden wird.

Zur Lösung dieser Aufgabe sieht die Erfindung bei einem Anwickel- und Lötanschluß gemäß Oberbegriff des Patentanspruches 1 vor, daß das erste und zweite Element mit ihren jeweils einen Enden in das Trägerteil eingebettet und einstückig miteinander verbunden sind, daß das freie Ende des ersten Elements stift-, streifen- oder lötösenförmig aus dem Trägerteil herausgeführt ist, und daß das freie Ende des zweiten Elements in Auflagerichtung des Bauelements auf die Leiterplatte gekrümmt ist.

Als Anwickel- und Lötanschluß ist z.B. ein Metallstreifen geeignet, dessen einer Teil - betrachtet in Steifenlängsrichtung - in zwei Streifen aufgetrennt ist, wobei einer der beiden Streifen bevorzugt ringförmig aufgebogen ist.

Der Anschluß kann auch als ein haarnadelförmig gekrümmter Drahtstift oder Metallstreifen ausgebildet sein, dessen eines Schenkelende gleichfalls bevorzugt ringförmig aufgebogen ist.

Zur Förderung der Stabilität kann das Stirnende des ringförmig aufgebogenen zweiten Elements in das Trägerteil zurückgeführt und eingebettet sein.

Die Erfindung wird nachstehend anhand eines Ausführungsbeispieles näher erläutert. Es zeigt:
- FIG 1: Eine Draufsicht auf einen in ein elektrisches Bauelement eingebetteten Anwickel- und Lötanschluß gemäß der Erfindung, wobei das Bauelement nur gebrochen dargestellt ist.
- FIG 2: Eine Seitenansicht des Anwickel- und Lötanschlusses nach FIG 1 nach erfolgter Tauchlötung, wobei gleiche Teile mit gleichen Bezugszeichen bezeichnet sind.

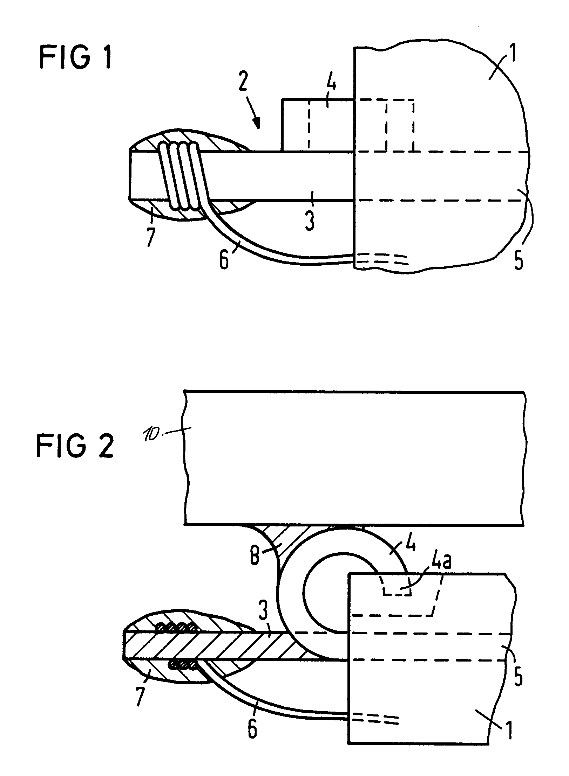

Der in FIG 1 mit zwei bezeichnete Anwickel- und Lötanschluß besitzt einen Metallstreifen, der mit seinem einen Teil 5 in ein Trägerteil 1 eines lediglich angedeuteten elektrischen Bauelements, z.B. Spulenkörpers, eingebettet ist. Der aus dem Trägerteil 1 herausgeführte Teil (5) des Metallstreifens ist - betrachtet in Streifenlängsrichtung - in zwei Streifen 3, 4 aufgetrennt, wobei der Streifen 4 ringförmig und zwar in Richtung der Auflage des Bauelements auf eine gebrochen angedeutete Leiterplatte 10 gekrümmt ist.

Zumindest das Stirnende 4a des ringförmig aufgebogenen Elements 4 ist in eine Ausnehmung des Trägerteils, z.B. eine Lötfahnenleiste eines Spulenkörpers zurückgeführt; ggf. kann es lagegesichert in das Trägerteil eingebettet sein.

Die mit 6 bezeichneten Spulenwicklungsenden sind an die Streifen 3 angewickelt und, wie dies mit 7 angedeutet ist durch Tauchlöten mit diesen verlötet. Die Lötung der ringförmig aufgebogenen Streifen 4 auf der Leiterplatte 10 erfolgt gleichfalls durch Tauchlöten, VP-Löten, IR-Löten oder Reflow-Löten - siehe Bezugszeichen 8 -.

Als Metallstreifen sind bevorzugt gestanzte Blechteile geeignet, die auch durch haarnadelförmig gekrümmte Drahtstifte oder Metallstreifen ersetztbar sind.

## Patentansprüche

1. Anwickel- und Lötanschluß für ein oberflächenmontierbares induktives elektrisches Bauelement, der in einem Trägerteil (1) des Bauelements gehalten ist und ein stift-, streifen- oder lötösenformiges erstes Element zum Anwickeln von Wickeldrahtenden und ein zweites Element zur Kontaktierung der Bauelemente auf einer Leiterplatte aufweist, **dadurch gekennzeichnet,** daß das erste und zweite Element (3, 4) mit seinem jeweils einen Ende in das Trägerteil (1) eingebettet und diese Enden einstückig miteinander verbunden sind, daß das freie Ende des ersten Elements (3) stift-, streifen- oder lötösenförmig aus dem Trägerteil (1) herausgeführt ist, und daß das freie Ende des zweiten Elements (4) in Richtung zur Auflage des Bauelements auf die Leiterplatte (10) gekrümmt ist.

2. Anwickel- und Lötanschluß nach Anspruch 1, **gekennzeichnet durch** einen Metallstreifen, dessen einer Teil - betrachtet in Streifenlängsrichtung - in zwei Streifen (3, 4) aufgetrennt ist, wobei einer der beiden Streifen (4) bevorzugt ringförmig aufgebogen ist.

3. Anwickel- und Lötanschluß nach Anspruch 1, **gekennzeichnet durch** einen haarnadelförmig gekrümmten Drahtstift, dessen eines Schenkelende bevorzugt ringförmig aufgebogen ist.

4. Anwickel- und Lötanschluß nach Anspruch 1, **gekennzeichnet durch** einen haarnadelförmig gekrümmten Metallstreifen, dessen eines Schenkelende bevorzugt ringförmig aufgebogen ist.

5. Anwickel- und Lötanschluß nach Anspruch 1 bis 4, **dadurch gekennzeichnet,** daß zumindest das Stirnende (4a) des ringförmig aufgebogenen zweiten Elements (4) in das Trägerteil (1) zurückgeführt und eingebettet ist.

6. Anwickel- und Lötanschluß nach Anspruch 1 bis 5, **gekennzeichnet durch** die Verwendung für Spulenkörper für elektrische Spulen.

## Claims

1. Wire-wrapped and solder connection (2) for a surface-mounted inductive electrical component, which is held in a support part (1) of the component and has a first element (3) in the form of a pin, strip or solder band, for the wire-wrapping of winding-wire ends, and has a second element (4) for making contact with the components on a printed-circuit board, characterised in that the first element (3) and second element (4) are embedded with in each case one of their ends in the supporting part (1) and these ends are integrally connected to one another, in that the free end of the first element (3) is passed out of the supporting part (1) in the form of a pin, strip or solder band, and in that the free end of the second element (4) is curved in the direction for the component to rest on the printed-circuit board (10).

2. Wire-wrapping and solder connection according to Claim 1, characterised by a metal strip whose one part - seen in the longitudinal direction - is separated into two strips (3, 4), one of the two strips (4) preferably being bent into a ring shape.

3. Wire-wrapping and solder connection according to Claim 1, characterised by a wire pin which is curved in a hairpin shape and whose one limb end is preferably bent into a ring shape.

4. Wire-wrapping and solder connection according to Claim 1, characterised by a metal strip which is curved in a hairpin shape and whose one limb end is preferably bent into a ring shape.

5. Wire-wrapping and solder connection according to Claims 1 to 4, characterised in that at least the end (4a) of the second element (4) which is bent into a ring shape is passed back into, and embedded in, the supporting part (1).

6. Wire-wrapping and solder connection according to Claims 1 to 5, characterised by use for coil formers for electrical coils.

## Revendications

1. Borne enroulée et brasée (2) pour un composant électrique inductif pouvant être monté en surface et qui est maintenue dans une partie de support (1) du composant, et un premier élément (3) en forme de tige, de bande ou de cosse à braser, pour l'enroulement d'extrémités d'un fil de bobinage, et un second élément (4) pour établir le contact entre les composants et une plaquette à circuits imprimés, caractérisée par le fait que les premier et second éléments (3, 4) sont respectivement enchâssés, par l'une de leurs extrémités, dans la partie de support (1) et que ces extrémités sont reliées entre elles d'un seul tenant, que l'extrémité libre du premier élément (3) ressort, sous la forme d'une tige, d'une bande ou d'une cosse à braser, hors de la partie de support (1) et que l'extrémité libre du second élément (4) est cintrée en vue de l'application du composant sur la plaquette à circuits imprimés (10).

2. Borne d'enroulement et de brasage suivant la revendication 1, caractérisée par une bande métallique, dont une partie est subdivisée - lorsqu'on regarde dans la direction longitudinale de la bande - en deux bandes (3, 4), dont l'une (4) est cintrée, de préférence avec une forme annulaire.

3. Borne d'enroulement et de brasage suivant la revendication 1, caractérisée par une tige formée d'un fil replié en épingle à cheveux, dont l'extrémité d'une branche est recourbée de préférence avec une forme annulaire.

4. Borne d'enroulement et de brasage suivant la revendication 1, caractérisée par une bande métallique cintrée en forme d'épingle à cheveux, dont une extrémité de branche est cintrée de préférence avec une forme annulaire.

5. Borne d'enroulement et de brasage suivant les revendications 1 à 4, caractérisée par le fait qu'au moins l'extrémité frontale (4a) du second élément (4) cintré avec une forme annulaire est renvoyée et est enchâssée dans la partie de support (1).

6. Borne d'enroulement et de brasage suivant les revendications 1 à 5, caractérisée par son utilisation pour des corps de bobines électriques.
